(19) Europäisches Patentamt

European Patent Office

Office européen des brevets

(11) **EP 0 545 829 B1**

(12) **EUROPEAN PATENT SPECIFICATION**

(45) Date of publication and mention
of the grant of the patent:
**30.10.1996   Bulletin 1996/44**

(51) Int Cl.[6]: **H01L 39/24**

(21) Application number: **92403295.6**

(22) Date of filing: **07.12.1992**

(54) **Connection of superconducting current paths formed of oxide superconductor material**

Aus supraleitendem Material hergestellte Verbindung supraleitender Leiterbahnen

Connexion des trajets supraconducteurs de courant fabriquée en matériau d'oxyde supraconducteur

(84) Designated Contracting States:
**DE FR GB**

(30) Priority: **05.12.1991   JP 348757/91**
**06.12.1991   JP 348965/91**
**09.12.1991   JP 350302/91**
**13.12.1991   JP 352195/91**
**03.12.1992   JP 350407/92**

(43) Date of publication of application:
**09.06.1993   Bulletin 1993/23**

(73) Proprietor: **Sumitomo Electric Industries, Ltd.**
**Osaka 541 (JP)**

(72) Inventors:
• **Inada, Hiroshi**
**F-75116 Paris (FR)**
• **Tanaka, So**
**F-75116 Paris (FR)**
• **Iiyama, Michitomo**
**F-75116 Paris (FR)**

(74) Representative: **Ballot, Paul Denis Jacques et al**
**Cabinet Ballot-Schmit,**
**7, rue Le Sueur**
**75116 Paris (FR)**

(56) References cited:
**EP-A- 0 477 063          DE-A- 4 212 028**

• **APPLIED PHYSICS LETTERS vol. 59, no. 21, 18 November 1991, NEW YORK, US, pages 2751-2753; Friedl G. et al.: 'Transport properties of epitaxial YBa2Cu3Ox films at step edges'**
• **PROCEEDINGS OF THE 4th INT'L CONFERENCE SQUID '91, 18-21 June 1991, pages 106-119, Berlin, G; Rogalla H.: "YBCO/PBCO/YBCO Edge Junctions and DC-SQUIDS"**

## Description

Background of the Invention

Field of the invention

The present invention relates to a superconducting device, and more specifically to a superconducting device including an oxide superconducting layer having a planar upper surface and a partially reduced thickness.

Description of related art

A superconducting current path is one of the electronic applications of a superconductor. If all the current paths of a conventional electronic circuit including semiconductor devices is replaced with superconducting current paths, completely, the electronic circuit will operate rapidly with low power consumption. Superconducting signal paths are also expected to reduce the wave form distortion so that the required number of amplifiers and/or repeaters can be reduced. Particularly, by using an oxide superconductor material which has been recently advanced in study, it is possible to produce a superconducting current path through which superconducting current flows at relatively high temperature.

In order to apply the superconducting current path of an oxide superconductor to a superconducting circuit, the superconducting current path is connected to another one or an device. It should also be taken into consideration a superconducting multilayer interconnection utilizing the oxide superconductor.

An oxide superconductor has the largest critical current density $J_c$ in direction perpendicular to $c$-axes of its crystal lattices. Therefore, it is desirable that the superconducting current path through which superconducting current flows horizontally is formed of a $c$-axis orientated oxide superconductor thin film and the superconducting path through which superconducting current flows vertically is formed of oxide superconductor thin films of which the $c$-axis is orientated horizontally. In this specification, this oxide superconductor thin film of which the $c$-axis is orientated horizontally will be called an "$a$-axis orientated oxide superconductor thin film".

A Josephson junction device is one of superconducting devices which is constituted of two superconducting electrodes joined by a Josephson junction. The Josephson junction can be realized in various structures. Among the various structures, the most preferable structure in practice is a stacked junction realized by a thin non-superconductor layer sandwiched between a pair of superconductors. However, a point contact type junction and a Dayem bridge type junction which are composed of a pair of superconductor regions which are weakly linked to each other also exhibit Josephson effect. In general, these Josephson junctions have fine structures in which the superconductor and/or non-superconductor are composed of thin films.

In order to realize a stacked type junction by using an oxide superconductor, a first oxide superconductor thin film, a non-superconductor thin film and a second oxide superconductor thin film are stacked on a substrate in the named order.

In the above mentioned stacked type junction, an insulator MgO etc., a semiconductor Si etc., and a metal Au etc. are used for the non-superconductor layers so that each superconducting junction has different properties for each application.

The thickness of the non-superconductor layer of the stacked type junction is determined by the coherence length of the superconductor. In general, the thickness of the non-superconductor layer of the stacked type junction must be within a few times of the coherence length of the superconductor. On the other hand, since oxide superconductor materials have a very short coherence length, therefore, a thickness of a non-superconductor layer must be about a few nanometers.

However, the superconductor layers and the non-superconductor layer of the stacked type junction must be of high crystallinity for favorable junction properties, which are composed of single crystals or composed of polycrystals which are orientated in almost same direction. It is difficult to stack an extremely thin and high crystalline non-superconductor layer on an oxide superconductor layer. Additionally, it is very difficult to stack a high crystalline oxide superconductor layer on the non-superconductor layers stacked on the first oxide superconductor layer. Though the stacked structure including a first oxide superconductor layer, a non-superconductor layer and a second oxide superconductor layer is realized, the interfaces between the oxide superconductor layers and the non-superconductor layer are not in good condition so that the stacked type junction does not function in good order.

In order to manufacture a point contact type junction and a Dayem bridge type junction by using oxide superconductor, very fine processings which realize a weak link between a pair of superconductor are necessary. It is very difficult to conduct a fine processing with good repeatability.

The point contact type junction has been formed of two oxide superconductor thin films which are in contact with each other in a extremely small area which constitutes the weak link of the Josephson junction.

The Dayem bridge type junction has been formed of a constant thickness oxide superconductor thin film which is formed on a substrate and which is pattemed in a plan view, so that a superconductor thin film region having a greatly narrow width is formed between a pair of superconductor thin film regions having a sufficient width. In other words, the pair of superconductor thin film regions having a sufficient width are coupled to each other by the superconductor thin film region having the greatly narrow- width. Namely, a weak link of the Josephson junction in the superconductor thin film is formed at the greatly narrow width region.

Such junction is described in the EP-A-0477063 (European Patent Application n° 91 402384.1) which relates to a superconducting device comprising a substrate having a projection formed in a principal surface and an oxide superconductor thin film formed to cover the projection and having a substantially planar surface, the oxide superconductor thin film including a thinned portion positioned on the projection and two thick portions positioned at both sides of the projection.

In order to resolve the above mentioned problems, so-called variable thickness bridge type Josephson device is proposed in a prior art. The variable thickness bridge type junction has been formed of an oxide superconductor thin film of a sufficient thickness which is formed on a substrate having a projection and which is partially thinned in a thickness direction on the projection of the substrate, so that a thinned oxide superconductor thin film portion is formed between a pair of superconductor thin films having the sufficient thickness. In other words, the pair of superconductor thin film portions having the sufficient thickness are coupled to each other by the thinned oxide superconductor thin film portion. Accordingly, a weak link of the Josephson junction is formed at the reduced thickness portion of the oxide superconductor thin film.

No fine processing, which is required to manufacture a point contact type Josephson junction device or a Dayem bridge type Josephson junction device, is necessary to manufacture the above mentioned variable thickness bridge type Josephson junction device

Josephson device is one of well-known superconducting devices. However, since Josephson device is a two-terminal device, a logic gate which utilizes Josephson devices becomes complicated. Therefore, three-terminal superconducting devices are more practical.

Typical three-terminal superconducting devices include two types of super-FET (field effect transistor). The first type of the super-FET includes a semiconductor channel, and a superconductor source electrode and a superconductor drain electrode which are formed closely to each other on both side of the semiconductor channel. A portion of the semiconductor layer between the superconductor source electrode and the superconductor drain electrode has a greatly recessed or undercut rear surface so as to have a reduced thickness. In addition, a gate electrode is formed through a gate insulator layer on the portion of the recessed or undercut rear surface of the semiconductor layer between the superconductor source electrode and the superconductor drain electrode.

A superconducting current flows through the semiconductor layer (channel) between the superconductor source electrode and the superconductor drain electrode due to a superconducting proximity effect, and is controlled by an applied gate voltage. This type of the super-FET operates at a higher speed with a low power consumption.

The second type of the super-FET includes a channel of a superconductor formed between a source electrode and a drain electrode, so that a current flowing through the superconducting channel is controlled by a voltage applied to a gate formed above the superconducting channel.

Both of the super-FETs mentioned above are voltage controlled devices which are capable of isolating output signal from input one and of having a well defined gain.

However, since the first type of the super-FET utilizes the superconducting proximity effect, the superconductor source electrode and the superconductor drain electrode have to be positioned within a distance of a few times the coherence length of the superconductor materials of the superconductor source electrode and the superconductor drain electrode. In particular, since an oxide superconductor has a short coherence length, a distance between the superconductor source electrode and the superconductor drain electrode has to be made less than about a few ten nanometers, if the superconductor source electrode and the superconductor drain electrode are formed of the oxide superconductor material. However, it is very difficult to conduct a fine processing such as a fine pattern etching, so as to satisfy the very short separation distance mentioned above.

On the other hand, the super-FET having the superconducting channel has a large current capability, and the fine processing which is required to product the first type of the super-FET is not needed to product this type of super-FET.

In order to obtain a complete ON/OFF operation, both of the superconducting channel and the gate insulating layer should have an extremely thin thickness. For example, the superconducting channel formed of an oxide superconductor material should have a thickness of less than five nanometers and the gate insulating layer should have a thickness more than ten nanometers which is sufficient to prevent a tunnel current.

In a prior art, a superconducting multilayer interconnection which has layered superconducting current paths constituted of $c$-axis orientated oxide superconductor thin films and a superconducting interconnect current path constituted of an $a$-axis orientated oxide superconductor thin film is proposed. However, grain boundaries are generated at the interface-between the $c$-axis orientated oxide superconductor thin film and the $a$-axis orientated oxide superconductor thin film, which introduce difficulties of superconducting current flow. The grain boundaries sometimes form Josephson junctions which pass only tunnel current so that the current capability is limited and the input and output relationships become nonlinear. Even if no Josephson junction is formed at the interface, Joule heat may be generated by the electrical resistance formed at the interface, which causes the "quench" phenomenon. Furthermore, the $c$-axis orientated oxide superconductor thin film and the $a$-axis orientated oxide superconductor thin film may interfere with each other so as to degrade them both.

The article titled "Transport properties of epitaxial $YBa_2Cu_3O_x$ films at step edges" Appl. Phys. Lett. Vol. 59, N°21, pp. 2751-2753 discloses an inclined interconnection structure between two superconducting current paths of an oxide superconductor arranged at different levels. Furthermore, the article titled "YBCO/PBCO/YBCO Edge Junctions and DC-SQUID's Proceeding of the 4th International Conference SQUID's 91 pp 106-119 describes a connecting structure between two superconducting current paths of an oxide superconductor arranged at the same plane.

The above variable thickness bridge type Josephson device and superconducting field effect device have portions at which thickness of the oxide superconductor thin films decreases sharply. The directions of superconducting current flow suddenly change at these portions so that the superconducting current capability is limited by these portions of the oxide superconductor thin films.

In this case, the superconducting current does not always flow in the direction perpendicular to the $c$-axes of the oxide superconductor crystals, so that the superconducting current can not flow efficiently.

## Summary of the Invention

Accordingly, it is an object of the present invention to provide a superconducting device which have overcome the above mentioned defects of the conventional ones.

Another object of the present invention is achieved in accordance with the present invention by a superconducting device comprising a substrate having a principal surface, an insulating region projected on the principal surface of the substrate and an oxide superconductor thin film formed on the principal surface of the substrate, which has a planar surface, two thick portions at the both sides of the insulating region and one thin portion on the insulating region characterized in that the insulating region has a trapezoid shape cross section of which both opposite side surfaces are inclined at an angle of less than 40° to the principal surface of the substrate in which the thick portions of the oxide superconductor thin film and the thin portion of the oxide superconductor thin film are smoothly connected each other along the inclined side surfaces of the insulating region so as to avoid abrupt change of sectional area of the oxide superconductor thin film so that current can efficiently flows between the thick portions and the thin portion.

In a preferred embodiment, the oxide superconductor is formed of high-$T_c$ (high critical temperature) oxide superconductor, particularly, formed of a high-$T_c$ copper-oxide type compound oxide superconductor for example a Y-Ba-Cu-O compound oxide superconductor material and a Bi-Sr-Ca-Cu-O compound oxide superconductor material.

In addition, the substrate can be formed of an insulating substrate, preferably an oxide single crystalline substrate such as MgO, $SrTiO_3$, $CdNdAlO_4$, etc. These substrate materials are very effective in forming or growing a crystalline film having a high degree of crystalline orientation.

The above and other objects, features and advantages of the present invention will be apparent from the following description of preferred embodiments of the invention with reference to the accompanying drawings.

## Brief Description of the Drawings

Figures 1 is a diagrammatic enlarged sectional view of a characteristic part of an embodiment of the superconducting circuit in accordance with the present invention;

Figures 2 is a diagrammatic sectional view of a first embodiment of the superconducting multilayer interconnection in accordance with the present invention;

Figure 3 is a diagrammatic sectional view of a second embodiment of the superconducting multilayer interconnection in accordance with the present invention;

Figure 4 is a diagrammatic sectional view of an embodiment of the Josephson junction device in accordance with the present invention; and

Figure 5 is a diagrammatic sectional view of an embodiment of the super-FET in accordance with the present invention.

## Description of the Preferred embodiments

## Embodiment 1

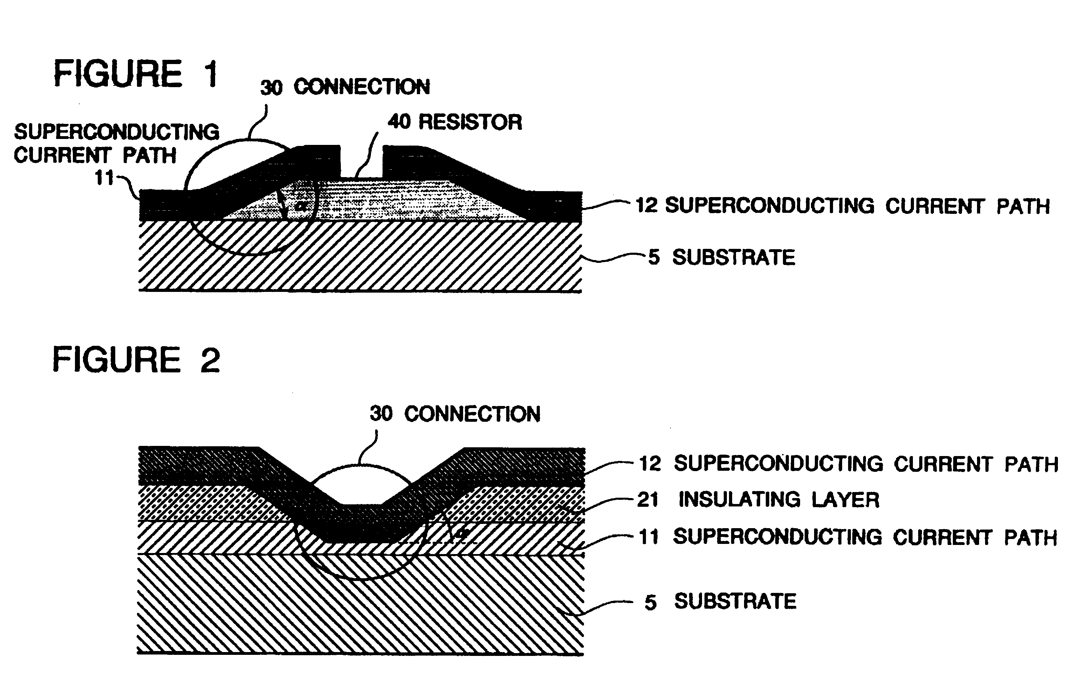

Referring to Figure 1 an embodiment of the the superconducting circuit in accordance with the present invention will be described. Figure 1 shows a diagrammatic sectional view of a characteristic part of an embodiment of the superconducting circuit in accordance with the present invention.

The superconducting circuit includes a resistor 40 of $Y_1Ba_2Cu_3O_{7-\epsilon}$ oxide semiconductor arranged on a principal surface of an MgO (100) substrate 5 and superconducting current paths 11 and 12 of $Y_1Ba_2Cu_3O_{7-\delta}$ oxide supercon-ductor, which are connected to the both ends of the resistor 40. Since the superconducting current paths 11 and 12 are connected to the resistor 40 in the same way, only the connection 30 of the superconducting current path 11 and the resistor 40 will be described.

In the superconducting circuit, the superconducting current paths 11 and 12 are formed of $c$-axis orientated $Y_1Ba_2Cu_3O_{7-\delta}$ oxide superconductor thin films, since $Y_1Ba_2Cu_3O_{7-\delta}$ oxide superconductor has the largest critical current density in the direction perpendicular to $c$-axes of its crystals. At the connection 30, the interface between the superconducting current path 11 and the resistor 40 is inclined at an angle $\alpha$ of 30° to the principal surface of the substrate 5. Therefore, the superconducting current path 11 does not deform sharply so that the crystalline structure of the $Y_1Ba_2Cu_3O_{7-\delta}$ oxide superconductor is not disordered at the connection 30.

The superconducting circuit was manufactured by the following process.

At first, the resistor 40 was formed of a $Y_1Ba_2Cu_3O_{7-\epsilon}$ oxide semiconductor thin film on the principal surface of the MgO (100) substrate 5. The $Y_1Ba_2Cu_3O_{7-\epsilon}$ oxide semiconductor thin film was deposited by a sputtering and patterned by a lift-off process utilizing CaO. The condition of forming the $Y_1Ba_2Cu_3O_{7-\epsilon}$ oxide semiconductor thin film is as follows:

| Temperature of the substrate | 800 °C |
|---|---|
| Sputtering Gas | Ar: 90% |
| | $O_2$: 10% |
| Total pressure | 6,6661 Pa ($5 \times 10^{-2}$ Torr) |
| Thickness of the thin film | 300 nanometers |

The both ends of the patterned $Y_1Ba_2Cu_3O_{7-\epsilon}$ oxide semiconductor thin film were processed by an ion beam etching so that the side surfaces of the edges were inclined at angle of 30° to the principal surface of the substrate 5. Then, the resistor 40 was completed. The resistor 40 had a resistance of several $k\Omega$.

Thereafter, the superconducting current paths 11 and 12 were formed of $c$-axis orientated $Y_1Ba_2Cu_3O_{7-\delta}$ oxide superconductor thin films on the principal surface of the substrate 5. The $c$-axis orientated $Y_1Ba_2Cu_3O_{7-\delta}$ oxide super-conductor thin films were formed by a sputtering. The condition of forming the $c$-axis orientated $Y_1Ba_2Cu_3O_{7-\delta}$ oxide superconductor thin film by a sputtering is as follows:

| Temperature of the substrate | 700°C |
|---|---|
| Sputtering Gas | Ar: 90% |
| | $O_2$: 10% |
| Total pressure | 6.6661 Pa ($5 \times 10^{-2}$ Torr) |
| Thickness of the thin film | 300 nanometers |

A conventional superconducting circuit which had the same structure as that of the above superconducting circuit was also formed except a resistor didn't have processed edges. The resistance measurements between the superconducting current paths 11 and 12 of the two superconducting circuit were made under liquid nitrogen cooling. In case of the superconducting circuit in accordance with the present invention, the resistance value was the same as that of the resistor 40 itself. On the contrary, in case of the conventional superconducting circuit, the value of the resistance was ten times larger than that of the resistor. Therefore, in the superconducting circuit in accordance with the present invention, the interface between the superconducting current path and the resistor was improved.

Embodiment 2

Referring to Figure 2 an embodiment of the superconducting multilayer interconnection in accordance with the present invention will be described. Figure 2 shows a diagrammatic sectional view of a characteristic part of an embodiment of the superconducting multilayer interconnection in accordance with the present invention.

The superconducting multilayer interconnection includes a first superconducting current path 11 formed of a $c$-axis orientated $Y_1Ba_2Cu_3O_{7-\delta}$ oxide superconductor thin film on a principal surface of an MgO substrate 5, an insulating layer 21 formed of MgO or silicon nitride on the superconducting current path 11 and a second superconducting current path 12 formed of a $c$-axis orientated $Y_1Ba_2Cu_3O_{7-\delta}$ oxide superconductor thin film on the insulating layer 21. The substrate 5 may includes a ground plane. The superconducting current path 12 has a portion which constitutes an interconnect current path penetrating the insulating layer 21 and contacting to the superconducting current path 11 at a connection 30.

The interconnect current path portion of the superconducting current path 12 descends at an angle $\alpha$, penetrates the insulating layer 21, smoothly contacts to the superconducting current path 11 and ascends at an angle $\alpha$. The angle $\alpha$ should be less than 40°, otherwise the crystal structure of the $c$-axis orientated $Y_1Ba_2Cu_3O_{7-\delta}$ oxide superconductor thin film which constitutes the superconducting current path 12 becomes disordered at the interconnect current path portion.

Embodiment 3

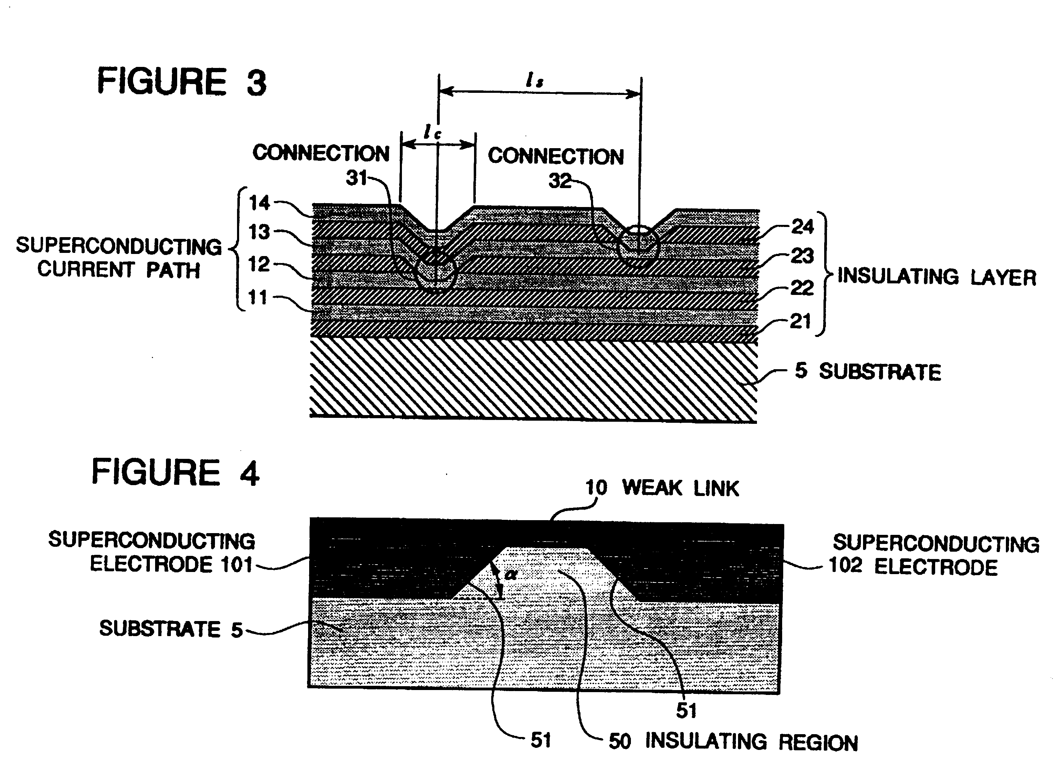

Figure 3 shows another preferred embodiment of the superconducting multilayer interconnection in accordance with the present invention, which includes four layers of superconducting current paths and two interconnect current path portions.

The superconducting multilayer interconnection includes an MgO substrate 5, insulating layers 21 to 24 and superconducting current paths 11 to 14 which are stacked alternately on the substrate 5. The insulating layers 21 to 24 are formed of MgO or silicon nitride and the superconducting current paths 11 to 14 are formed of $c$-axis orientated $Y_1Ba_2Cu_3O_{7-\delta}$ oxide superconductor thin films. The substrate 5 may include a ground plane. The superconducting current path 13 has a portion which constitutes an interconnect current path penetrating the insulating layer 23 and smoothly contacting to the superconducting current path 12 at a connection 31 and the superconducting current path 14 has a portion which constitutes an interconnect current path penetrating the insulating layer 24 and smoothly contacting to the superconducting current path 13 at a connection 32. The tilt angles $\alpha$ of the interconnect current path portions of the superconducting multilayer interconnection are less then 40° as is the same as Embodiment 2. The relation between distance 1, between the connections 31 and 32 and the widths $l_c$ is as follows:

$$l_s \approx 2.5 \times l_c \text{ to } 3.0 \times l_c$$

In the above superconducting multilayer interconnection, each of the interconnect current paths connects the two neighboring superconducting current paths and does not connects three or more superconducting current paths. Since an interconnect current path which connects three or more superconducting current paths should require a large horizontal cross-sectional area because of current capability requirement, the density of the wiring is decreased. In addition, a large depression is formed at an interconnect current path portion which connects three or more superconducting current paths so that it becomes different to stack superconducting current path on it. Therefore, the interconnect current path preferably connects only the two neighboring superconducting current paths.

In the above superconducting multilayer interconnection, a superconducting current path can be formed on a connection. Even a superconducting current path which cross a interconnection current path above it can be formed. Therefore, the superconducting multilayer interconnection in accordance with the present invention has a high degree of freedom of wiring superconducting current paths with interconnect current paths so that a complicated wiring and a high density wiring can be easily composed. Even if a complicated wiring is composed of the superconducting multilayer interconnection, the current capability does not decrease.

Embodiment 4

Referring to Figure 4 an embodiment of the Josephson junction device in accordance with the present invention will be described. Figure 4 shows a diagrammatic sectional view of an embodiment of the Josephson junction device in accordance with the present invention.

The Josephson junction device includes an MgO substrate 5 having a projecting insulating region 50 of which the cross section is a shape of a trapezoid and superconducting electrodes 101 and 102 coupled to each other by a weak link 10 of a Josephson junction on the insulating region 50. Each of the surfaces 51 of the insulating region 50 is inclined at angle $\alpha$ of 35°.

The superconducting electrodes 101 and 102 and the weak link 10 are formed of a $c$-axis orientated $Y_1Ba_2Cu_3O_{7-\delta}$ oxide superconductor thin film, namely sufficiently thick portions of the $c$-axis orientated $Y_1Ba_2Cu_3O_{7-\delta}$ oxide superconductor thin film constitute the superconducting electrodes 101 and 102 and a thin portion of the $c$-axis orientated $Y_1Ba_2Cu_3O_{7-\delta}$ oxide superconductor thin film between the two thick portions constitutes the weak link 10. The $c$-axis orientated $Y_1Ba_2Cu_3O_{7-\delta}$ oxide superconductor thin film is constituted of uniform crystalline $Y_1Ba_2Cu_3O_{7-\delta}$ oxide superconductor even near the inclined surfaces 51 of the insulating region 50. The uniformity of the $c$-axis orientated $Y_1Ba_2Cu_3O_{7-\delta}$ oxide superconductor thin film is achieved by the inclined angles a of 35° of the surfaces 51 of the insulating region 50.

Since the Josephson junction device is formed of an uniform *c*-axis orientated $Y_1Ba_2Cu_3O_{7-\delta}$ oxide superconductor thin film and the the superconducting electrodes 101 and 102 are smoothly connected to the weak link portion 10, current flowing through the superconducting electrodes 101 and 102 efficiently flows into or from the weak link portion 10. Therefore, the Josephson junction device has a high performance.

The Josephson junction device was manufactured by the following process.

At first, an insulating region 50 having a height of 0.3 μm was formed by an ion-milling using Ar gas on a principal surface of an MgO (100) substrate 5 having a size of 15 mm × 8mm and a thickness of 0.5 mm. In order to incline the surfaces 51 at angles α of 35°, the Ar ions were irradiated diagonally. The inclined surfaces 51 can also be 5 formed by a side-etching using a seeking effect of etchunt.

Then, the substrate 5 was heated to a temperature of 350 to 400 °C under a pressure lower than $1.33322 \times 10^{-7}$ Pa ($1 \times 10^{-9}$ Torr) in order to clean the etched surfaces. Thereafter, a *c*-axis orientated $Y_1Ba_2Cu_3O_{7-\delta}$ oxide superconductor thin film was formed on the principal surface of the substrate 5 by a sputtering. The condition of forming the *c*-axis orientated $Y_1Ba_2Cu_3O_{7-\delta}$ oxide superconductor thin film by a sputtering is as follows:

| | |
|---|---|
| Temperature of the substrate | 700°C |
| Sputtering Gas | Ar: 90% |
| | $O_2$: 10% |
| Total pressure | 6.6661Pa ($5 \times 10^{-2}$ Torr) |
| Thickness of the thin film | 300 nanometers |

Finally, the *c*-axis orientated $Y_1Ba_2Cu_3O_{7-\delta}$ oxide superconductor thin film was etched back so that a planar surface Was formed. Then, the Josephson junction device in accordance with the present invention was completed.

Embodiment 5

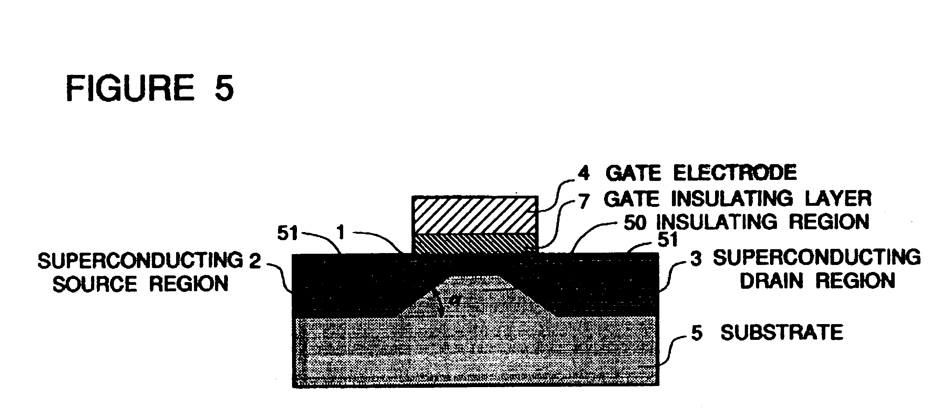

Referring to Figure 5 an embodiment of the super-FET in accordance with the present invention will be described. Figure 5 shows a diagrammatic sectional view of an embodiment of the super-FET in accordance with the present invention.

The super-FET includes an MgO substrate 5 having a projecting insulating region 50 of which the cross section is a shape of a trapezoid and a superconducting source region 2 and a superconducting drain region 3 electrically connected by a superconducting channel 1 on the insulating region 50. Each of the surfaces 51 of the insulating region 50 is inclined at angle α of 35°.

The superconducting source region 2 and the superconducting drain region 3 and the superconducting channel 1 are formed of a *c*-axis orientated $Y_1Ba_2Cu_3O_{7-\delta}$ oxide superconductor thin film, namely sufficiently thick portions of the *c*-axis orientated $Y_1Ba_2Cu_3O_{7-\delta}$ oxide superconductor thin film constitute the superconducting source region 2 and the superconducting drain region 3 and a thin portion of the *c*-axis orientated $Y_1Ba_2Cu_3O_{7-\delta}$ oxide superconductor thin film between the thick portions constitutes the superconducting channel 1. The superconducting source region 2 and the superconducting drain region 3 have a thickness of on the order of 200 nanometers and the superconducting channel has a thickness of on the order of 5 nanometers. The gate insulating layer 7 is formed of silicon nitride or MgO having a thickness of on the order of 15 nanometers. The gate electrode 4 is formed of Au.

The *c*-axis orientated $Y_1Ba_2Cu_3O_{7-\delta}$ oxide superconductor thin film is constituted of uniform crystalline $Y_1Ba_2Cu_3O_{7-\delta}$ oxide superconductor even near the inclined surfaces 51 of the insulating region 50. The uniformity of the *c*-axis orientated $Y_1Ba_2Cu_3O_{7-\delta}$ oxide superconductor thin film is achieved by the inclined angles α of 35° of the surfaces 51 of the insulating region 50.

Since the superconducting portion of the super-FET is formed of an uniform *c*-axis orientated $Y_1Ba_2Cu_3O_{7-\delta}$ oxide superconductor thin film and the superconducting channel 1 is smoothly connected to the superconducting source region 2 and the superconducting drain region 3, there is no undesired junction nor resistance at this portion and current flowing through the superconducting source region 2 and the superconducting drain region 3 efficiently flows into or from the superconducting channel 1. Therefore, the super-FET has a high performance.

The super-FET was manufactured by the following process.

At first, an insulating region 50 having a trapezoid shape cross section was formed by a reactive ion etching or an ion-milling using Ar gas on a principal surface of an MgO (100) substrate 5. In order to incline the surfaces 51 at angles α of 35°, ions were irradiated diagonally.

Then, the substrate 5 was heated to a temperature of 350 to 400 °C under a pressure lower than $1.3332 \times 10^{-7}$ Pa ($1 \times 10^{-9}$ Torr) in order to clean the etched surfaces.. Thereafter, a *c*-axis orientated $Y_1Ba_2Cu_3O_{7-\delta}$ oxide superconductor thin film was formed on the principal surface of the substrate 5 by a sputtering. The condition of forming the *c*-axis orientated $Y_1Ba_2Cu_3O_{7-\delta}$ oxide superconductor thin film by a sputtering is as follows:

| Temperature of the substrate | 700°C |
|---|---|
| Sputtering Gas | Ar: 90% |
| | $O_2$: 10% |
| Total pressure | 6.6661Pa ($5 \times 10^{-2}$ Torr) |
| Thickness of the thin film | 200 nanometers |

Then, the $c$-axis orientated $Y_1Ba_2Cu_3O_{7-\delta}$ oxide superconductor thin film was etched back so that a planar surface was formed. Thick portions of the $c$-axis orientated $Y_1Ba_2Cu_3O_{7-\delta}$ oxide superconductor thin film at the both sides of the insulating region 50 would be a superconducting source region 2 and a superconducting drain region 3. A thin portion of the $c$-axis orientated $Y_1Ba_2Cu_3O_{7-\delta}$ oxide superconductor thin film on the insulating region 50 would be a superconducting channel 1. A gate insulating layer 7 was formed of MgO or silicon nitride on a portion of the $c$-axis orientated $Y_1Ba_2Cu_3O_{7-\delta}$ oxide superconductor thin film above the insulating region 50 and a gate electrode 4 was formed of Au on the gate insulating layer 7. Metal electrodes might be formed on the superconducting source region 2 and superconducting drain region 3, if necessary. Then, the super-FET in accordance with the present invention was completed.

In the above mentioned embodiments, the oxide superconductor thin film can be formed of not only the Y-Ba-Cu-O compound oxide superconductor material, but also a high-$T_c$ (high critical temperature) oxide superconductor material, particularly a high-$T_c$ copper-oxide type compound oxide superconductor material, for example a Bi-Sr-Ca-Cu-O compound oxide superconductor material.

The invention has thus been shown and described with reference to the specific embodiments. However, it should be noted that the present invention is in no way limited to the details of the illustrated structures but converts and modifications may be made within the scope of the appended claims.

## Claims

1. A superconducting device comprising a substrate (5) having a principal surface, an insulating region (50) projected on the principal surface of the substrate (5) and an oxide superconductor thin film formed on the principal surface of the substrate, said thin film having a planar surface, two thick portions (101, 102, 2, 3) at the both sides of the insulating region (50) and one thin portion (10, 1) on the insulating region (50) **characterized in that** the insulating region (50) has a trapezoid shape cross section of which both opposite side surfaces (51) are inclined at an angle of less than 40° to the principal surface of the substrate (5), in that the thick portions (101, 102, 2, 3) of the oxide superconductor thin film and the thin portion (10, 1) of the oxide superconductor thin film are smoothly connected each other along the inclined side surfaces (51) of the insulating region (50) so as to avoid an abrupt change of sectional area of the oxide superconductor thin film so that current can efficiently flow between the thick portions (101, 102, 2, 3) and the thin portion (10, 1).

2. A superconducting device claimed in Claim 1 **characterized in that** the oxide superconductor thin film is formed of high-$T_c$ (high critical temperature) oxide superconductor, particularly, formed of a high-$T_c$ copper-oxide type compound oxide superconductor.

3. A superconducting device claimed in Claim 2 **characterized in that** the oxide superconductor thin film is formed of oxide superconductor material selected from the group consisting of a Y-Ba-Cu-O compound oxide superconductor material and a Bi-Sr-Ca-Cu-O compound oxide superconductor material.

4. A superconducting device claimed in anyone of Claims 1 to 3 **characterized in that** the thick portions of the oxide superconductor thin film constitute superconducting electrodes (101, 102) and the thin portion of the oxide superconductor thin film constitutes a weak link (10) of a Josephson junction so as to form a Josephson junction device.

5. A superconducting device claimed in anyone of Claims 1 to 3 **characterized in that** the device further comprises a gate electrode (4) on the thin portion of the oxide superconductor thin film through a gate insulating layer (7) in which the thick portions of the oxide superconductor thin film constitute a superconducting source region (2) and a superconducting drain region (3), and the thin portion of the oxide superconductor thin film constitutes a superconducting channel (1) and current flowing between the superconducting source region (2) and the superconducting drain region (3) through the superconducting channel (1) is controlled by a signal voltage applied to the gate electrode (4) so as to form a superconducting field effect device.

**Patentansprüche**

1. Supraleitende Anordnung, mit einem Substrat 5, das eine Hauptoberfläche aufweist, einen isolierenden Bereich 50, die aus der Hauptoberfläche des Substrates 5 hervorspringt und mit einer oxidischen supraleitenden Dünnschicht, die auf der Hauptoberfläche des Substrates ausgebildet ist, wobei diese Dünnschicht eine ebene Oberfläche aufweist und zwei dicke Abschnitte 101, 102, 2, 3 zu beiden Seiten des isolierenden Bereichs 50 und einen dünnen Abschnitt 101 auf dem isolierenden Bereich 50 aufweist, dadurch gekennzeichnet, daß der isolierende Bereich 50 einen trapezförmigen Querschnitt aufweist, dessen beide gegenüberliegende Seitenflächen 51 unter einem Winkel von weniger als 40° zur Hauptoberfläche des Substrates 5 geneigt sind, daß die dicken Abschnitte 101, 102, 2, 3 der oxidischen supraleitenden Dünnschicht und der dünne Abschnitt 10, 1 der oxidischen supraleitenden Dünnschicht übergangslos miteinander verbunden sind entlang der geneigten Seitenflächen 51 des isolierenden Bereichs 50, um so einen plötzlichen Übergang der Querschnittsfläche der oxidischen supraleitenden Dünnschicht zu vermeiden, so daß ein Strom wirksam zwischen den dicken Abschnitten 101, 102, 2, 3 und dem dünnen Abschnitt 10, 1 fließen kann.

2. Supraleitende Anordnung nach Anspruch 1, dadurch gekennzeichnet, daß die oxidische supraleitende Dünnschicht aus einem oxidischen Supraleiter mit hoher Tc (hoher kritischer Temperatur) besteht und insbesondere aus einem oxidischen Supraleiter aus einem

3. Supraleitende Anordnung nach Anspruch 2, dadurch gekennzeichnet, daß die oxidische supraleitende Dünnschicht aus einem oxidischem supraleitendem Material besteht, das ausgewählt ist aus der Gruppe bestehend aus einem supraleitenden Y-Ba-Cu-O-Verbundoxid und einem supraleitenden Bi-Sr-Ca-Cu-O-Verbundoxid.

4. Supraleitende Anordnung nach einem der Ansprüche 1 bis 3, dadurch gekennzeichnet, daß die dicken Abschnitte der oxidischen supraleitenden Dünnschicht supraleitende Elektroden 101, 102 darstellen und daß der dünne Abschnitt der oxidischen supraleitenden Dünnschicht eine schwache Verbindung 10 eines Josephson-Übergangs darstellt, um so eine Josephson-Übergangs-Anordnung zu bilden.

5. Supraleitende Anordnung nach einem der Ansprüche 1 bis 3, dadurch gekennzeichnet, daß die Anordnung außerdem eine Gate-Elektrode 4 auf dem dünnen Abschnitt der oxidischen supraleitenden Dünnschicht oberhalb einer isolierenden Gate-Schicht 7 aufweist, wobei die dicken Abschnitte der oxidischen supraleitenden Dünnschicht einen supraleitenden Source-Bereich 2 und einen supraleitenden Drain-Bereich 3 bilden, während der dünne Abschnitt der oxidischen supraleitenden Dünnschicht einen supraleitenden Kanal 1 bildet, wobei ein Strom der zwischen dem supraleitenden Source-Bereich 2 und dem supraleitenden Drain-Bereich 3 durch den supraleitenden Kanal 1 fließt, durch eine Signalspannung steuerbar ist, welche an die Gate-Elektrode 4 gelegt wird, so daß eine supraleitende Feldeffekt-Anordnung gebildet wird.

**Revendications**

1. Dispositif supraconducteur comprenant un substrat (5) comportant une surface principale , une zone isolante (50) en saillie sur la surface principale du substrat (5) et un film mince de supraconducteur d'oxyde formé sur la surface principale du substrat, ledit film mince comportant une surface plane, deux parties épaisses (101, 102, 2, 3) au niveau des deux côtés de la zone isolante (50) et une partie mince (10,1) sur la zone isolante (50) , caractérisé en ce que la zone isolante (50) présente une section transversale de forme trapézoïdale dont les deux surfaces latérales opposées (51) sont inclinées en formant un angle inférieur à 40° par rapport à la surface principale du substrat (5) , en ce que les parties épaisses (101, 102, 2,3) du film mince de supraconducteur d'oxyde et la partie mince (10,1) du film mince de supraconducteur d'oxyde sont connectées de façon régulière les unes aux autres le long des surfaces latérales inclinées (51) de la zone isolante (50) de façon à éviter un changement brusque de surface de section du film mince de supraconducteur d'oxyde, de façon que le courant puisse efficacement circuler entre les parties épaisses (101, 102, 2 , 3) et la partie mince (10,1) .

2. Dispositif supraconducteur selon la revendication 1 , caractérisé en ce que le film mince de supraconducteur d'oxyde est formé d'un supraconducteur d'oxyde à $T_c$ élevée (température critique élevée), particulièrement, constitué d'un supraconducteur d'oxyde composé du type oxyde de cuivre à $T_c$ élevée.

3. Dispositif supraconducteur selon la revendication 2, caractérisé en ce que le film mince de supraconducteur d'oxyde est formé d'un matériau supraconducteur d 'oxyde sélectionné dans le groupe constitué d'un matériau supraconducteur d'oxyde composé de Y-Ba-Cu-O et d'un matériau supraconducteur d'oxyde composé de Bi-Sr-Ca-Cu-O.

4. Dispositif supraconducteur selon l'une quelconque des revendications 1 à 3 , caractérisé en ce que les parties épaisses du film mince de supraconducteur d'oxyde constituent des électrodes supraconductrices (101, 102) et la partie mince du film mince de supraconducteur d'oxyde constitue une liaison faible (10) d'une jonction Josephson de façon à former un dispositif à jonction Josephson.

5. Dispositif supraconducteur selon l'une quelconque des revendications 1 à 3, caractérisé en ce que le dispositif comprend, de plus, une électrode de grille (4) sur la partie mince du film mince de supraconducteur d'oxyde, à travers une couche d'isolement de grille (7), dans lequel les parties épaisses du film mince de supraconducteur d'oxyde constituent une zone de source supraconductrice (2) et une zone de drain supraconductrice (3), et la partie mince du film mince de supraconducteur d'oxyde constitue un canal supraconducteur (1) et la circulation de courant entre la zone de source supraconductrice (2) et la zone de drain supraconductrice (3) à travers le canal supraconducteur (1) est commandée par une tension de signal appliquée à l'électrode de grille (4) de façon à former un dispositif supraconducteur à effet de champ.

EP 0 545 829 B1

# FIGURE 1

30 CONNECTION

40 RESISTOR

SUPERCONDUCTING CURRENT PATH
11

12 SUPERCONDUCTING CURRENT PATH

5 SUBSTRATE

# FIGURE 2

30 CONNECTION

12 SUPERCONDUCTING CURRENT PATH

21 INSULATING LAYER

11 SUPERCONDUCTING CURRENT PATH

5 SUBSTRATE

EP 0 545 829 B1

## FIGURE 3

CONNECTION
31

CONNECTION
32

$l_s$

$l_c$

SUPERCONDUCTING
CURRENT PATH

14
13
12
11

24
23
22
21
INSULATING LAYER

5 SUBSTRATE

## FIGURE 4

10 WEAK LINK

SUPERCONDUCTING
ELECTRODE 101

SUPERCONDUCTING
102 ELECTRODE

SUBSTRATE 5

$\alpha$

51

51

50 INSULATING REGION

# FIGURE 5

**4 GATE ELECTRODE**
**7 GATE INSULATING LAYER**
**50 INSULATING REGION**
**51**
**3 SUPERCONDUCTING DRAIN REGION**
**5 SUBSTRATE**
**1**
**51**
**SUPERCONDUCTING 2 SOURCE REGION**